# EUROPEAN PATENT SPECIFICATION

(11) **EP 0 355 833 B1**
(45) Date of publication and mention of the grant of the patent: **26.01.1994**
(21) Application number: 89115642.4
(22) Date of filing: 24.08.1989
(51) Int. Cl.: C30B 15/14

(54) **Method of producing compound semiconductor single crystal**
Verfahren zur Herstellung eines Einkristalls aus einer Halbleiter-Verbindung
Méthode de production d'un monocristal de composé semi-conducteur

(30) Priority: 25.08.1988 JP 211099/88
(43) Date of publication of application: 28.02.1990
(73) Proprietor: SHIN-ETSU HANDOTAI COMPANY LIMITED, Chiyoda-ku Tokyo (JP)
(72) Inventor: Kaise, Tuneyuki Sakuragaoka-Dormitory, Annaka-shi Gunma-ken (JP); Matsumoto, Hazime, Usui-gun Gunma-ken (JP); Ikeda, Jun Shinpu-Dormitory, Annaka-shi Gunma-ken (JP)
(74) Representative: Patentanwälte Leinweber & Zimmermann

(56) References cited:
- EP-A- 0 140 509
- EP-A- 0 141 495
- DE-A- 2 942 057
- PATENT ABSTRACTS OF JAPAN, vol. 11, no. 24 (C-399)[2471], 23rd January 1987; & JP-A-61 197 499 (MITSUBISHI MONSANTO CHEM. CO.) 01-09-1986

## Description

### BACKGROUND OF THE INVENTION

### 1. Field of the Invention:

The present invention relates to a method of producing a compound semiconductor single crystal, according to the preamble of claim 1 (EP 0 141 495 A1) and more particularly to a method of producing a high quality single crystal so as to reduce the occurrance of cracks and crystallographic defects of the crystal to a minimum while growing a compound semiconductor single crystal.

### 2. Description of Related Art:

Because a V group element is volatile, a liquid encapsulated Czochralski method has heretofore been used to obtain a large-sized single crystal of a III-V group compound semiconductor. This liquid encapsulated Czochralski method is advantageous in that a III-V group compound, which changes in volume during the crystallization, can be crystallized easily. For example, growth of a single crystal is accomplished by sealing a melt of a starting crystal material with a liquid sealing agent such as boron oxide (B₂O₃), retarding the dissociation of a V group element, such as phosphorus, arsenic, etc., which is high in dissociation pressure, in a high pressure ambient gas of 3 to 70 atm., dipping a seed crystal to the melt and pulling the seed crystal at a predetermined speed while rotating.

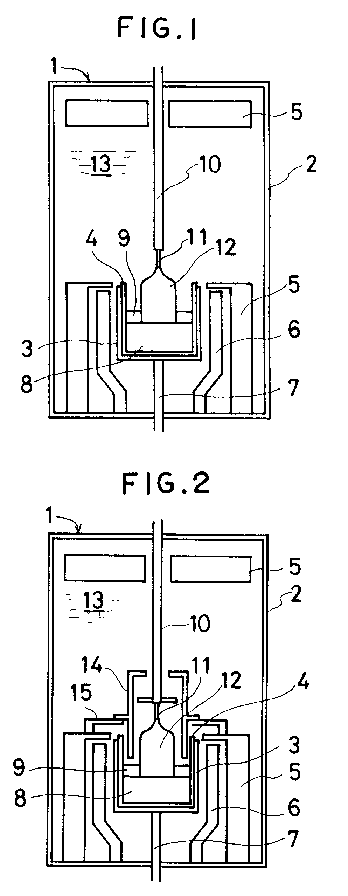

This liquid encapsulated Czochralski method will now be described in detail with reference to FIG. 1 of the accompanying drawings. FIG. 1 shows a single crystal pulling apparatus 1 comprising a high pressure vessel 2, a graphite crucible holder 3, a quartz crucible 4, a graphite shield tube 5, a heater 6 and a crucible rotating shaft 7. In the quartz crucible 4, for example, polycrystal of GaP and a low melting point glass sealant (e.g. B₂O₃) are charged. The quartz crucible 4 is placed in the high pressure vessel 2 , which is filled and pressurized with an inert gas 13 such as argon, nitrogen, etc. up to a high pressure of 3.10⁵Pa to 70.10⁵Pa (3 to 70 atm). The quartz crucible 4 is heated up to a temperature of more than 1470°C (1260°C in case of GaAs, and 1100°C in case of InP) to melt GaP and B₂O₃ in the quartz crucible 4 completely, thus providing a GaP melt 8 and a layer of melted B₂O₃ liquid (liquid sealant) 9 on the GaP melt 8. Then, a seed crystal 11 attached to the lower end of pulling shaft 10 is dipped into the GaP melt 8 through the melted B₂O₃ layer 9, and is pulled slowly while rotating, at a predetermined speed. As a result, a single crystal 12 of GaP grows.

However, with this liquid encapsulated Czochralski method, cracks would tend to occur in the crystal, and occurrance of dislocations, one of crystal defects, could not be prevented. Yet, even in the absence of any cracks, a high quality compound semiconductor single crystal could not be manufactured because of inevitable crystal defects accompanying.

A variety of solutions have hitherto been proposed: Japanese Patent Publications Nos. 60-6916 and 60-18637 disclose the concept of defining a low temperature gradient region in the vicinity of an interface between a liquid sealant and a melt of a starting crystal material; Japanese Patent Laid-Open Publication No. 61-291492 discloses the concept of setting a temperature difference between a liquid sealant and a melt of a starting crystal material to a most suitable value; Japanese Patent Publication No. 61-17798 and Japanese Patent Laid-Open Publication No. 61-186291 disclose the concept of increasing the thickness of a layer of the liquid sealant; and Japanese Patent Publication No. 60-6917 discloses the concept of covering the surface of a single crystal with a liquid sealant while the crystal grows. The use of the liquid sealant is also known from EP 0 141 495 A1. In the method described in said reference, the temperature gradient in the vertical direction near the solid-liquid interface is controlled to be preferably 5 to 30°C/cm by dividing a heating means in two or more heaters. Similar methods or apparatus, respectively, are furthermore known from JP-A-61 197 449 and EP-0 140 509 A1. Namely, in none of these proposals the temperature drop of the single crystal within the sealing liquid is controlled. Therefore it is difficult to improve the crystalline quality of the grown single crystal by adjusting the temperature gradient of the single crystal part exposed to the ambient gas. However, by any of these known proposals, a satisfactory compound semiconductor single crystal of high quality could not be produced.

### SUMMARY OF THE INVENTION

The object underlying the invention, therefore, is to solve the above problem, i.e. to make it possible to efficiently improve the crystalline quality of the grown single crystal by adjusting the temperature gradient of the single crystal part exposed to the ambient gas.

According to the present invention, the above object can be accomplished according to characterizing clause of Claim 1.

Further, it is preferred that the temperature gradient should be applied in the crystallized region above the upper surface of the liquid sealant upto a point at which a temperature is lower by 30% of the melting point in centigrade than the same. Preferably, the temperature gradient of a crystallized part at an interface between the liquid sealant and the ambient gas is lower than the remaining portions.

If the above mentioned cooling temperature gradient exceeds 30°C/cm, the density of dislocations is over 10⁵/cm²; if the temperature gradient does not reach 5°C/cm, the crystal does not grow at economically reasonable speeds. More preferably, the temperature gradients in the case of Ga^{P}, GaAs and InP are 15-25°C/cm, 10-15°C/cm and 8-13°C/cm, respectively.

Various concepts for providing the above-mentioned cooling temperature gradient may be adapted; for example, if a mixture of argon gas (Ar) and nitrogen gas (N₂) in the 3:2 ratio by volume is used, the cooling temperature gradient of 27°C/cm can be obtained. The ambient gas may contain less than 50% by volume of nitrogen gas and the rest of argon gas. Otherwise, a purge tube, a hot Zone, etc. may be disposed around the pulled crystal for the purpose of cooling or heating in order to set the cooling temperature gradient within the preferable range according to the present invention.

The above and other advantages, features and additional objects of the present invention will become manifest to those skilled in the art upon reference to the detailed description and the accompanying drawings in which two apparatus for carrying out the method of the present invention are shown by way of illustrative examples.

### BRIEF DESCRIPTION OF THE DRAWINGS

FIG. 1 is a schematic vertical cross-sectional view of an apparatus for producing a compound semiconductor single crystal; and
FIG. 2 is a view similar to FIG. 1, showing a modified apparatus using a shield tube.

### DETAILED DESCRIPTION

The method of the present invention comprises exposing a single crystal ( to be pulled ) to an ambient gas where temperature of the single crystal does not drop very much, adjusting the exposed part of the single crystal so as to have an adequately low temperature gradient, i.e. a range of 5 to 30°C by setting the composition of ambient gas and other factors, thereby reducing the occurrance of cracks and other crystallographic defects remarkably.

If nitrogen gas alone is used as the ambient gas, the cooling temperature gradient along the exposed single crystal region is 43°C/cm, which is not preferable. Therefore the ambient gas should not be nitrogen gas alone.

If argon gas alone is used as the ambient gas, the cooling temperature gradient is 20°C/cm, which is preferable to the nitrogen as an ambient gas. Further, in order to obtain a low temperature gradient of 5°C/cm, it is necessary to shield heat by a suitable means. For example, as shown in FIG. 2, a hollow cylindrical quartz shield tube 14 is disposed over a quartz crucible 4 coaxially of the pulling shaft 10 so as to surround the single crystal 12, or pressure of the ambient gas may be lowered.

Generally, in the sealing liquid, the constant temperature gradient prevails at steep about 130°C/cm. With this temperature gradient, the temperature of the single crystal would be lowered in the sealing liquid remarkably to a temperature below the melting point of the single crystal by more than 100 °C, e.g. by 300 °C to 400 °C, to 1000 °C in the case of GaP. In this conventional case, it is difficult to improve the crystalline quality of the grown single crystal by adjusting the temperature gradient of the single crystal part exposed to the ambient gas.

In the present method, it is preferable to adjust lowering of the temperature of the single crystal in the liquid sealant to a minimum. Namely, it is preferable that the temperature of the single crystal immediately after having passed the liquid surface of the liquid sealant is prevented from lowering below the melting point by at most 100 °C.

To adjust the lowering of the temperature of the single crystal in the liquid sealant to a minimum, the crucible is charged with a compound semiconductor material, and boron oxide added on it, in such a manner that the melt of the boron oxide at about 400 °C slightly covers the whole charge of the unmelted compound semiconductor material. The boron oxide liquid layer normally has a thickness of about 10 mm on the melt of the compound semiconductor material upon the complete melting. As long as it can seal the melt of the compound semiconductor material, it is preferred that the thickness of the liquid sealant layer is as thin as possible. This is true because the thinner the liquid sealant layer becomes, the more quickly the single crystal can pass through the layer into the ambient gas. As a result, at its higher temperature stage, the single crystal can be gradually cooled at the optimum temperature gradient according to the present invention.

According to the present invention, the cooling temperature gradient in the direction of growth of the single crystal part exposed to the ambient gas is defined within the range of 5 to 30°C/cm, so that occurrance of cracks and dislocations of the crystal can be reduced to a minimum, thus enabling the production of a high-quality compound semiconductor single crystal of minimum defect.

### Example 1

Using a single crystal pulling apparatus similar to the apparatus of FIG. 1, a quartz crucible with an inside diameter of 96 mm and a height of 100 mm was charged with 800 g of a polycrystal of GaP and an amount of B₂O₃ for forming a sealing layer with a thickness of about 8 mm. This crucible was placed in a high pressure vessel, and the vessel was filled with a mixture of argon gas and nitrogen gas at the 3:2 ratio by volume and was pressurized at about 70.10⁵Pa (70 atm).

Subsequently, the crucible was heated up to about 1500°C with the charge in it by a heater to form an upper layer of melted B₂O₃ liquid and a melt of GaP. Then, a seed crystal was slowly dipped into the melt of GaP and then was pulled upward at a speed of 12 mm/hour while rotating at a predetermined rotation speed. At that time, the cooling temperature gradient of the pulled single crystal was 27°C/cm. This pulling operation was continued for nine hours to form a cylindrical single crystal of GaP weighing 702 g and having a diameter of 50 mm and a length of 113 mm. The same pulling operation was repeated several times, and the rate of occurrance of a crack or cracks of the grown single crystals of GaP and the etch pit density (EPD) thereof were measured. As a result, the rate of occurrance of a crack or cracks of the single crystals was 20%, and the EPD thereof was on average 8 x 10⁴/cm² for the highest in each single crystal. Thus, single crystals with low rates of occurrance of cracks and less dislocations were obtained.

### Comparative Example 1

The procedure of Example 1 was followed except that nitrogen gas alone was used instead of the mixture of argon gas and nitrogen gas. At that time, the cooling temperature gradient of the pulled single crystal was 43°C/cm. The pulling operation was continued for nine hours to form a cylindrical single crystal weighing 698 g and having a dimeter of 50 mm and a length of 110 mm. This pulling operation was repeated several times, and the rate of occurrance of a crack or cracks of the grown single crystals of GaP and the etch pit density (EPD) thereof were measured. As a result, the rate of occurrance of a crack or cracks of the single crystals was 60%, and the EPD thereof was on average of the highest in each single crystal 3 x 10⁵/cm².

### Example 2

The procedure of Example 1 was followed except that an apparatus of Fig. 2 was used instead of the apparatus of Fig. 1. Unlike the apparatus of FIG. 1, the apparatus of FIG. 2 includes a quartz shield tube 14 and a shield tube support 15. The shield tube 14 made possible direct observation of crystal growing through it by optical means or the naked eye and also to minimize convection loss of heat from the pulled crystal. At that time, the cooling temperature gradient of the pulled crystal was 17 °C/cm. The pulling operation was continued for nine hours to form a cylindrical single crystal of GaP weighing 700 g and having a diameter of 50 mm and a length of 110 mm. This pulling operation was repeated several times, and the rate of occurrance of a crack or cracks of the grown single crystals of GaP and the EPD thereof were measured. As a result, the rate of occurance of a crack or cracks of the single crystals was substantially 0%, and the EPD thereof was on average of the highest in each crystal 9 x 10³/cm². Thus good quality single crystals were obtained, as there occurred no cracks and fewer dislocations, as compared with the results in Example 1.

## Claims

1. A method of producing a compound semiconductor single crystal, comprising sealing a melt (8) of compound semiconductor crystal material with a liquid sealant (9), dipping a seed crystal (11) to the melt, pulling the seed crystal into a high pressure ambient gas (13) to grow a single crystal, and setting temperature gradients within a range of 5 to 30°C/cm both in the direction of growth of the part of the single crystal exposed to the ambient gas as the single crystal grows, and at the outer surface of the liquid sealant and a portion contiguous thereto of the exposed part of the single crystal, characterized in that the temperature of the single crystal to be pulled through the liquid sealant (9) is set to a temperature lower than a melting point of the crystal by at most about 100° C in the liquid sealant.

2. A method according to Claim 1, characterized in that the thickness of the liquid sealant (9) is not exceeding 10 mm and enough to be able to seal the melt (8) of the compound semiconductor material.

3. A method of producing a compound semiconductor single crystal according to Claim 1 or 2, characterized in that the ambient gas is a mixture of nitrogen gas and argon gas, the content of nitrogen gas being less than 50% by volume.

## Patentansprüche

1. Verfahren zum Herstellen eines Verbindungshalbleiter-Einkristalls, welches umfaßt das Versiegeln einer Schmelze (8) eines Verbindungshalbleiterkristallmaterials mit einem flüssigen Versiegelungsmittel (9), Eintauchen eines Impfkristalls (11) in die Schmelze, Ziehen des Impfkristalls in ein Hochdruck-Umgebungsgas (13) zum Wachsenlassen eines Einkristalls und Einstellen von Temperaturgradienten innerhalb eines Bereichs von 5 bis 30°C/cm sowohl in der Wachstumsrichtung des Teils des Einkristalls, der dem Umgebungsgas während des Wachstums des Einkristalls ausgesetzt ist, als auch an der Außenoberfläche des flüssigen Versiegelungsmittels und einem daran angrenzenden Bereich des freiliegenden Teils des Einkristalls, dadurch gekennzeichnet, daß die Temperatur des durch das flüssige Versiegelungsmittel (9) zu ziehenden Einkristalls in dem flüssigen Versiegelungsmittel auf eine Temperatur eingestellt wird, die um höchstens etwa 100°c niedriger ist als ein Schmelzpunkt des Kristalls.

2. Verfahren nach Anspruch 1, dadurch gekennzeichnet, daß die Dicke des flüssigen Versiegelungsmittels (9) 10 mm nicht übersteigt und ausreichend ist, um die Schmelze (8) des Verbindungshalbleitermaterials zu versiegeln.

3. Verfahren zur Herstellung eines Einkristalls aus einem Verbindungshalbleiter nach Anspruch 1 oder 2, dadurch gekennzeichnet, daß das Umgebungsgas eine Mischung von Stickstoffgas und Argongas ist, wobei der Stickstoffgasgehalt weniger als 50 Vol.-% ist

## Revendications

1. Méthode de production d'un monocristal d'un composé semi-conducteur consistant à obturer un produit fondu (8) du matériau de cristal du composé semi-conducteur au moyen d'un agent liquide d'obturation (9), à immerger un cristal d'ensemencement (11) dans le produit fondu, à tirer le cristal d'ensemencement dans le gaz ambiant à haute pression (13) pour faire croître un monocristal et régler les gradients de température entre 5 et 30°C/cm aussi bien dans la direction de la croissance de la partie du monocristal qui est exposée au gaz ambiant tandis que le monocristal croît qu'à la surface externe de l'agent liquide d'obturation et une portion qui lui est contigue de la partie exposée du monocristal, caractérisée en ce que la température du monocristal à tirer à travers l'agent liquide d'obturation (9) est établie à une température plus faible qu'un point de fusion du cristal au plus d'environ 100°C dans l'agent liquide d'obturation.

2. Méthode selon la revendication 1, caractérisée en ce que l'épaisseur de l'agent liquide d'obturation (9) ne dépasse pas 10 mm et qu'elle est suffisante pour permettre d'obturer le produit fondu (8) du composé semi-conducteur.

3. Méthode de production d'un monocristal d'un composé semi-conducteur selon la revendication 1 ou 2, caractérisée en ce que le gaz ambiant est un mélange d'azote gazeux et d'argon gazeux, le contenu de l'azote gazeux étant inférieur à 50% en volume.
